# DEMANDE DE BREVET EUROPEEN

(11) **EP 4 092 892 A1**
(43) Date de publication de la demande: **23.11.2022**
(21) Numéro de dépôt: 22174241.4
(22) Date de dépôt: 19.05.2022
(51) Int. Cl.: H02M 1/08, H02M 3/158, H02M 1/00, H03K 4/50

(54) **ALIMENTATION À DÉCOUPAGE**

(30) Priorité: 20.05.2021 FR 2105281
(71) Demandeur: STMicroelectronics (Rousset) SAS, 13790 Rousset (FR)
(72) Inventeur: ORTET, Sebastien, 13790 CHATEAUNEUF-LE-ROUGE (FR)
(74) Mandataire: Cabinet Beaumont

(57) **Abrégé**

La présente description concerne une alimentation à découpage (10) comprenant un générateur (50) de rampes de tension, le générateur (50) étant configuré pour que la capacité de sortie du générateur (50) de rampes de tension ait une première valeur durant un premier cycle de fonctionnement d'un premier mode de fonctionnement et ait une deuxième valeur durant les cycles de fonctionnement suivants du premier mode de fonctionnement.

## Description

### Domaine technique

La présente description concerne de façon générale les circuits électroniques, et concerne plus particulièrement les convertisseurs de tension de type alimentation à découpage ("Switched Mode Power Supply") ou SMPS et leur fonctionnement. Plus précisément, la présente description concerne les alimentations à découpage comprenant un générateur de tension.

### Technique antérieure

Dans un convertisseur de tension de type alimentation à découpage, une tension d'alimentation du convertisseur est découpée (ou hachée) en commutant des interrupteurs de manière à mettre en œuvre des phases d'accumulation d'énergie dans un ensemble comprenant un élément inductif et un élément capacitif et des phases de restitution, à une charge connectée en sortie du convertisseur, de l'énergie accumulée dans cet ensemble.

Un convertisseur de tension de type alimentation à découpage peut par exemple fonctionner dans un mode de fonctionnement dit mode de conduction continue (« Continuous Conduction Mode » - CCM), par exemple de type PWM, c'est-à-dire à modulation d'amplitude d'impulsion ("Pulse Width Modulation") ou de type PFM, c'est-à-dire à modulation de fréquence d'impulsion ("Pulse Frequency Modulation"). Le convertisseur de tension peut par exemple aussi fonctionner dans un mode de fonctionnement dit mode de suppression d'impulsion (« Pulse Skipping » - PSK).

Le passage d'un mode à un autre peut être problématique. En effet, ce passage peut entrainer une chute de tension sur la sortie du convertisseur.

### Résumé de l'invention

Un mode de réalisation pallie tout ou partie des inconvénients des convertisseurs de tension de type alimentation à découpage connus.

Un mode de réalisation prévoit une alimentation à découpage comprenant un générateur de rampes de tension, le générateur étant configuré pour que la capacité de sortie du générateur de rampes de tension ait une première valeur durant un premier cycle de fonctionnement d'un premier mode de fonctionnement et ait une deuxième valeur durant les cycles de fonctionnement suivants du premier mode de fonctionnement.

Un autre mode de réalisation prévoit un procédé de commande d'une alimentation à découpage comprenant un générateur de rampes de tension, dans lequel la capacité de sortie du générateur de rampes de tension a une première valeur durant un premier cycle de fonctionnement d'un premier mode de fonctionnement et a une deuxième valeur durant les cycles de fonctionnement suivants du premier mode de fonctionnement.

Selon un mode de réalisation, le générateur comprend un premier condensateur et au moins un deuxième condensateur, les premier et deuxième condensateurs étant couplés entre un noeud de sortie du générateur sur lequel est généré une rampe de tension et un noeud d'application d'une tension de référence, le au moins un deuxième condensateur étant couplé en série avec un interrupteur entre le noeud de sortie et le noeud d'application de la tension de référence, l'interrupteur étant configuré pour être fermé durant le premier cycle de fonctionnement du premier mode de fonctionnement et ouvert durant le reste des cycles de fonctionnement du premier mode de fonctionnement.

Selon un mode de réalisation, le premier condensateur est relié en série avec un interrupteur entre le noeud de sortie et le noeud d'application de la tension de référence.

Selon un mode de réalisation, le générateur de rampes de tension comprend au moins deux deuxièmes condensateurs.

Selon un mode de réalisation, au moins certains des interrupteurs reliés en série avec les deuxièmes condensateurs sont commandés par des signaux de commande différents.

Selon un mode de réalisation, le premier mode de fonctionnement est un mode de conduction continue.

Selon un mode de réalisation, l'alimentation comprend un deuxième circuit de commande du premier mode de fonctionnement, le deuxième circuit comprenant un premier comparateur configuré pour comparer une tension de sortie de l'alimentation et une tension de consigne et un deuxième comparateur configuré pour comparer une sortie du premier comparateur à une rampe de tension généré par le générateur de rampes de tension, le deuxième comparateur étant configuré pour fournir un signal de sortie au premier circuit.

Selon un mode de réalisation, l'alimentation comprend un deuxième mode de fonctionnement dit mode de suppression d'impulsion.

Selon un mode de réalisation, l'alimentation comprend un troisième circuit de commande du deuxième mode de fonctionnement comprenant un troisième comparateur configuré pour comparer une rampe de tension générée par le générateur de rampes de tension et une tension de consigne, le troisième comparateur étant configuré pour fournir un deuxième signal de sortie au premier circuit.

Selon un mode de réalisation, l'alimentation comprend des premier et deuxième transistors reliés en série entre un noeud d'application d'une tension d'alimentation et un noeud d'application d'une tension de référence, les premier et deuxième transistors étant reliés l'un à l'autre par un nœud interne, les premier et deuxième transistors étant commandés par un premier circuit de génération des signaux de commande des premier et deuxième transistors.

Selon un mode de réalisation, le générateur de rampes de tension comprend : - une résistance reliée en série avec un premier transistor entre le noeud d'application de la tension d'alimentation et le noeud d'application de la tension de référence ; - un deuxième transistor et un troisième transistor reliés en série entre le noeud d'application de la tension d'alimentation et le noeud d'application de la tension de référence ; - un quatrième transistor couplé entre le noeud d'application de la tension d'alimentation et le noeud de sortie, les deuxièmes et quatrième transistors étant reliés en miroir de courant ; et un amplificateur opérationnel, une entrée de l'amplificateur opérationnel étant reliée à un noeud reliant la résistance et le premier transistor et une autre entrée de l'amplificateur opérationnel étant reliée à un noeud d'application d'une tension sensiblement égale à la moitié de la tension d'alimentation, une sortie de l'amplificateur opérationnel étant reliée aux bornes de commande des premier et troisième transistors.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un convertisseur de tension ;
la figure 2 représente un mode de réalisation d'un générateur de rampes de tension ; et
la figure 3 est un ensemble de chronogrammes illustrant le fonctionnement du mode de réalisation de la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

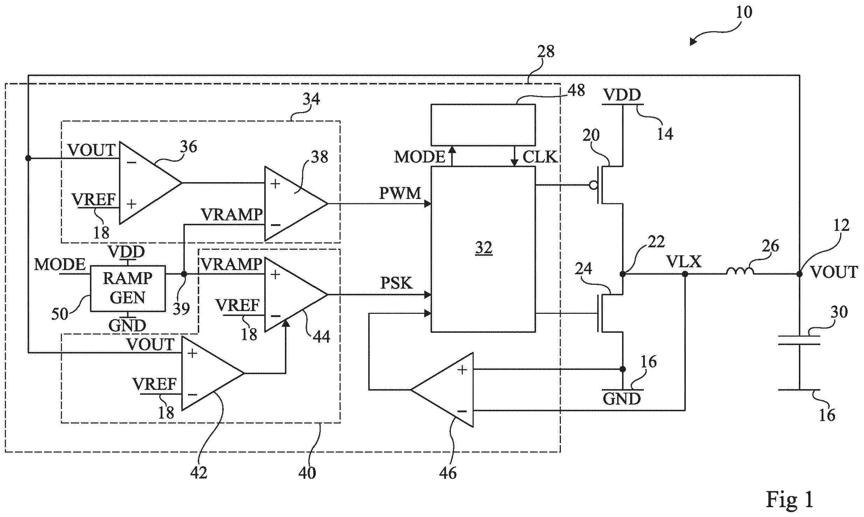

La figure 1 représente un mode de réalisation d'un convertisseur de tension 10. Le convertisseur 10 est un convertisseur DC/DC, de type alimentation à découpage, ou une alimentation à découpage, qui convertit une tension continue (DC) d'alimentation en une tension continue (DC) de sortie.

Le convertisseur 10 est configuré pour fournir une tension continue de sortie VOUT. Le convertisseur comprend un noeud de sortie 12, sur lequel est disponible la tension VOUT.

Le convertisseur 10 est alimenté par une tension continue d'alimentation VDD. Le convertisseur 10 est alors connecté entre un premier rail conducteur, ou noeud, 14 mis à la tension VDD, et un deuxième rail conducteur, ou noeud, 16 mis à un potentiel de référence GND, par exemple la masse.

Le convertisseur 10 est configuré pour fournir la tension VOUT à une valeur sensiblement égale à une valeur de consigne. Pour cela, le convertisseur 10 reçoit, sur un noeud d'entrée 18, une tension continue de consigne VREF, par exemple référencée par rapport au potentiel GND, dont la valeur est représentative de la valeur de consigne de la tension VOUT, de préférence égale à la valeur de consigne de la tension VOUT. Dans cet exemple, les tensions VOUT, VDD et VREF sont positives.

Dans cet exemple, le convertisseur 10 est de type abaisseur ou « buck », c'est-à-dire que la valeur de consigne de la tension VOUT est inférieure à la valeur de la tension VDD. Autrement dit, la valeur de la tension VOUT est inférieure à celle de la tension VDD.

Le convertisseur 10 comprend un premier transistor MOS ("metal oxyde semiconductor" - métal oxyde semiconducteur) 20, de préférence un transistor PMOS (transistor MOS à canal P). Le transistor MOS 20 est connecté entre le rail 14 et un noeud interne 22 sur lequel est appliquée une tension VLX. Dit autrement, une première borne de conduction du transistor 20, par exemple sa source, est connectée au rail 14, une deuxième borne de conduction du transistor 20, par exemple son drain, étant connectée au noeud 22.

Le convertisseur 10 comprend en outre un deuxième transistor MOS 24, de préférence un transistor NMOS (transistor MOS à canal N) . Le transistor 24 est connecté entre le noeud 22 et le rail 16. Autrement dit, une première borne de conduction du transistor 24, par exemple sa source, est connectée au rail 16, une deuxième borne de conduction du transistor 24, par exemple son drain, étant connectée au noeud 22.

Ainsi, les transistors 20 et 24 sont connectés en série entre les rails 14 et 16, et sont connectés l'un à l'autre au niveau du noeud interne 22.

Le convertisseur 10 comprend un élément inductif ou inductance 26. L'inductance 26 est connectée entre le noeud 22 et le noeud 12.

Le convertisseur 10 comprend une capacité 30 connectée entre le noeud 12 et le rail 16. A titre d'exemple, cette capacité est de l'ordre de 2,2 µF à 20 µF, voire plus. Cette capacité joue le rôle de filtre. Dit autrement, cette capacité du convertisseur permet de lisser le courant présent sur le noeud 12 et de stocker de l'énergie fournie au noeud 12 par le convertisseur.

En fonctionnement, une charge non représentée est connectée entre le noeud 12 et le rail 16 de manière à être alimentée par la tension VOUT.

Le convertisseur 10 comprend un circuit de commande 28. Le circuit 28 est configuré pour commander le fonctionnement du convertisseur 10, de manière à réguler la tension VOUT, par exemple pour que sa valeur soit égale à la valeur de consigne VREF.

Le convertisseur 10 comprend deux modes de fonctionnement, un mode de fonctionnement synchrone et un mode de fonctionnement asynchrone.

Un premier mode de fonctionnement est dit mode de conduction continue (« Continuous Conduction Mode » - CCM), par exemple de type PWM, c'est-à-dire à modulation d'amplitude d'impulsion ("Pulse Width Modulation") ou de type PFM, c'est-à-dire à modulation de fréquence d'impulsion ("Pulse Frequency Modulation"), dans lequel chaque cycle de fonctionnement du convertisseur comprend une phase d'accumulation d'énergie dans l'inductance 26 et le condensateur 30 suivie d'une phase de restitution d'énergie à la charge connectée au convertisseur. Pendant la phase d'accumulation d'énergie, le courant traversant l'élément inductif 26 augmente. Pendant la phase de restitution d'énergie, le courant traversant l'élément inductif 26 diminue. Ce mode de fonctionnement est un mode synchrone, synchronisé par un signal binaire d'horloge CLK, par exemple à une fréquence de 2,4 MHz. Un tel mode de fonctionnement est par exemple considéré le mode de fonctionnement normal du convertisseur.

Un deuxième mode de fonctionnement est dit mode de suppression d'impulsion (« Pulse Skipping » - PSK). Dans ce mode de fonctionnement, le transistor 24 est par exemple maintenu bloqué et le transistor 20 est rendu passant lorsque la tension de sortie VOUT est inférieure à une tension de référence, par exemple la tension de consigne VREF. Ainsi, une phase d'accumulation d'énergie est mise en œuvre lorsque la tension de sortie est inférieure à la tension de consigne VREF. Un tel mode de fonctionnement est par exemple mis en œuvre lorsque le courant tiré par la charge est faible. Ce mode de fonctionnement est un mode de fonctionnement asynchrone.

Le circuit de commande 28 comprend un circuit 32, par exemple une machine d'état, générant les signaux de commande des transistors 20 et 24. Le circuit 32 comprend ainsi une sortie reliée, de préférence connectée, à la borne de commande du transistor 20, sur laquelle est fournie le signal de commande du transistor 20. Le circuit 32 comprend de plus une sortie reliée, de préférence connectée, à la borne de commande du transistor 24, sur laquelle est fournie le signal de commande du transistor 24.

Le circuit 32 comprend, en outre, une entrée reliée à un circuit 34 de commande du premier mode de fonctionnement, sur laquelle le circuit 32 reçoit un signal PWM déterminant, selon la différence entre la tension de sortie VOUT et la tension de consigne VREF, l'amplitude ou la fréquence des phases d'accumulation ou de restitution d'énergie dans le premier mode de fonctionnement. Ainsi, le signal PWM est utilisé par le circuit 32 dans le premier mode de fonctionnement et est par exemple inutilisé durant le deuxième mode de fonctionnement.

Le circuit 34 comprend par exemple un comparateur 36 configuré pour comparer la tension de sortie VOUT à la tension de consigne VREF. Le comparateur 36 comprend une entrée, de préférence une entrée non inverseuse, reliée, de préférence connectée, au noeud 18 d'application de la tension VREF. Le comparateur 36 comprend, en outre, une entrée, de préférence une entrée inverseuse, reliée, de préférence connectée, au noeud 12. Le comparateur 36 comprend une sortie sur laquelle est fournie un signal représentatif de la différence entre la tension VOUT et la tension de consigne VREF.

Le circuit 34 comprend un autre comparateur 38. Le comparateur 38 comprend une entrée, de préférence une entrée non inverseuse, reliée, de préférence connectée, à la sortie du comparateur 36. Le comparateur 38 comprend en outre une autre entrée, de préférence une entrée inverseuse, reliée, de préférence connectée, à un noeud 39 d'application d'une rampe de tension VRAMP. Le comparateur 38 comprend une sortie sur laquelle il fournit le signal PWM. La sortie du comparateur est reliée, de préférence connectée, à une des entrées du circuit 32.

Le circuit 32 comprend, en outre, une entrée reliée à un circuit 40. Le circuit 40 est configuré pour commander le deuxième mode de fonctionnement. Le circuit 32 reçoit sur cette entrée un signal PSK représentatif de la différence entre la tension de sortie VOUT et la tension de consigne VREF. Le circuit 32 détermine, à partir du signal PSK, les débuts des phases d'accumulation d'énergie au cours du deuxième mode de fonctionnement. Autrement dit, pour une première valeur du signal PSK, obtenue lorsque la tension de sortie est inférieure à la tension de consigne VREF, le transistor 20 est passant de manière à permettre la charge du condensateur 30 et le transistor 24 est bloqué. Pour une deuxième valeur du signal PSK, le transistor 20 est bloqué, et le transistor 24 est passant. Ainsi, le signal PSK est utilisé par le circuit 32 dans le deuxième mode de fonctionnement et est par exemple inutilisé durant le premier mode de fonctionnement.

Le circuit 40 comprend par exemple un comparateur 42 configuré pour comparer la tension de sortie VOUT à la tension de consigne VREF. Le comparateur 40 comprend une entrée, de préférence une entrée inverseuse, reliée, de préférence connectée, au noeud 18 d'application de la tension VREF. Le comparateur 40 comprend, en outre, une entrée, de préférence une entrée non inverseuse, reliée, de préférence connectée, au noeud 12. Le comparateur 40 comprend une sortie sur laquelle est fournie un signal représentatif de la différence entre la tension VOUT et la tension de consigne VREF.

Le circuit 34 comprend un autre comparateur 44. Le comparateur 44 comprend une entrée, de préférence une entrée non inverseuse, reliée, de préférence connectée, au noeud 39 d'application de la rampe de tension VRAMP. Le comparateur 44 comprend en outre une autre entrée, de préférence une entrée inverseuse, reliée, de préférence connectée, au noeud 18 d'application de la tension de consigne VREF. Le comparateur 44 comprend une entrée de commande reliée, de préférence connectée, à la sortie du comparateur 42. Le comparateur 44 comprend une sortie sur laquelle le signal PSK est fourni pour une valeur du signal de sortie du comparateur 42. La sortie du comparateur est reliée, de préférence connectée, à une des entrées du circuit 32.

Ainsi, lorsque le convertisseur 10 est dans le premier mode de fonctionnement, le circuit 32 prend en compte le signal PWM pour déterminer les signaux de commande des transistors 20 et 24 et ne prend pas en compte le signal PSK. Lorsque le convertisseur 10 est dans le deuxième mode de fonctionnement, le circuit 32 prend en compte le signal PSK pour déterminer les signaux de commande des transistors 20 et 24 et ne prend pas en compte le signal PWM.

Le circuit 28 comprend par exemple un comparateur 46. Le comparateur 46 comprend une première entrée, de préférence une entrée non inverseuse, reliée, de préférence connectée, au noeud 16 d'application de la tension GND, et une deuxième entrée, de préférence une entrée inverseuse, reliée, de préférence connectée, au noeud 22. Le comparateur 46 comprend une sortie reliée, de préférence connectée, au circuit 32, fournissant un signal représentatif de la différence entre la tension VLX sur le noeud 22 et la tension sur le noeud 16. Autrement dit, le comparateur fournit au circuit 32 un signal représentatif du signe de la tension VLX. Si le convertisseur fonctionne dans le premier mode de fonctionnement et que le comparateur détermine que la tension VLX est supérieure à la tension GND en fin de cycle d'horloge, le circuit 32 fait entrer le convertisseur dans le deuxième mode de fonctionnement.

Le circuit 28 comprend par exemple un circuit 48 de génération du signal d'horloge CLK. Le circuit 28 comprend ainsi une sortie reliée, de préférence connectée, au circuit 32 sur laquelle est fourni le signal CLK.

Le circuit 48 comprend une entrée reliée, de préférence connectée, au circuit 32 sur laquelle est fourni un signal MODE représentatif du mode de fonctionnement du convertisseur. Par exemple, le signal MODE prend une première valeur lorsque le convertisseur 10 fonctionne dans le premier mode de fonctionnement et une deuxième valeur lorsque le convertisseur 10 fonctionne dans le deuxième mode de fonctionnement. Le signal MODE prend donc la deuxième valeur lorsque le convertisseur passe du premier au deuxième mode de fonctionnement, autrement dit lorsque le comparateur 46 détermine que la tension VLX est supérieure à la tension GND. Le signal MODE prend par exemple la première valeur lorsque le courant tiré par la charge augmente fortement.

Le circuit 28 comprend en outre un circuit 50 (RAMP GEN) de génération de la rampe de tension VRAMP. Le circuit 50 reçoit de préférence la tension d'alimentation VDD et la tension de référence GND. Ainsi, le circuit 50 comprend une entrée reliée, de préférence connectée, au noeud 14 et une entrée reliée, de préférence connectée, au noeud 16. Le circuit 50 reçoit en outre un signal de commande, par exemple le signal MODE. Le circuit 50 comprend donc une entrée reliée, de préférence connectée, à un noeud d'application du signal de commande. Le circuit 50 comprend en outre une sortie sur laquelle est généré la rampe de tension VRAMP. Cette sortie est reliée, de préférence connectée, au noeud 39.

Le générateur 50 est tel que sa capacité de sortie, c'est-à-dire la capacité du condensateur total relié entre la sortie du générateur de rampe de tension sur laquelle est générée la rampe de tension VRAMP et le noeud de référence, durant le premier cycle de fonctionnement du premier mode de fonctionnement est supérieure à sa capacité de sortie durant les cycles de fonctionnement suivants du premier mode de fonctionnement.

Le générateur 50 de rampes de tension comprend, de préférence couplés entre le noeud de sortie du générateur et le noeud de référence, au moins deux condensateurs, au moins un de ces condensateurs étant couplé en série avec un interrupteur entre un noeud 68 et le noeud 16. Ledit interrupteur étant configuré pour être fermé durant le premier cycle de fonctionnement, c'est-à-dire durant la première phase d'accumulation d'énergie et la première phase de restitution d'énergie, après le passage du deuxième mode de fonctionnement au premier mode de fonctionnement et ouvert durant le reste des cycles de fonctionnement du premier mode de fonctionnement.

Lors du passage du deuxième mode de fonctionnement au premier mode de fonctionnement, il peut exister une durée durant laquelle une grande quantité d'énergie est tirée par la charge. Le courant traversant l'inductance à la fin d'un cycle du deuxième mode de fonctionnement étant nul, le condensateur 30 se décharge rapidement durant cette période, ce qui peut entrainer une chute non négligeable de la tension alimentant la charge.

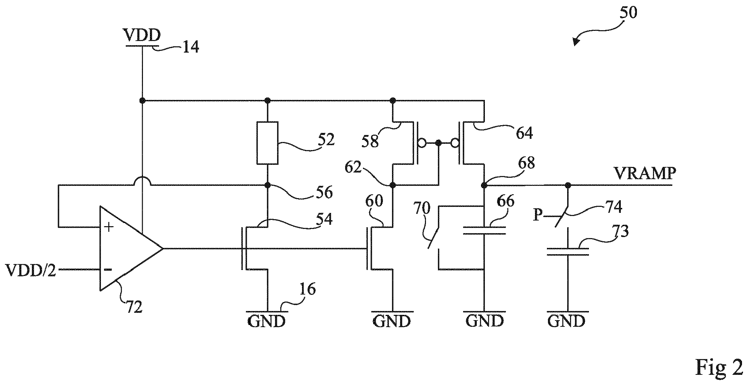

La figure 2 représente un mode de réalisation d'un générateur 50 de rampes de tension.

Le générateur 50 comprend une résistance 52 et un transistor 54, par exemple un transistor NMOS, en série entre le noeud 14 d'application de la tension d'alimentation VDD et le noeud 16 d'application de la tension de référence GND. Plus précisément, la résistance 52 est reliée entre le noeud 14 et un noeud 56. Le transistor 54 est relié entre le noeud 56 et le noeud 16. Plus précisément, une borne de la résistance 52 est reliée, de préférence connectée, au noeud 14 et une autre borne de la résistance 52 est reliée, de préférence connectée, au noeud 56. Une borne du transistor 54, par exemple une borne de conduction, c'est-à-dire le drain ou la source, est reliée, de préférence connectée, au noeud 56 et une autre borne, par exemple l'autre borne de conduction, est reliée, de préférence connectée, au noeud 16.

Le générateur 50 comprend un transistor 58, par exemple un transistor PMOS, et un transistor 60, par exemple un transistor NMOS, en série entre le noeud 14 d'application de la tension d'alimentation VDD et le noeud 16 d'application de la tension de référence GND. Plus précisément, le transistor 58 est reliée entre le noeud 14 et un noeud 62. Le transistor 60 est relié entre le noeud 62 et le noeud 16. Plus précisément, une borne du transistor 58, par exemple une borne de conduction, c'est-à-dire le drain ou la source, est reliée, de préférence connectée, au noeud 14 et une autre borne, par exemple l'autre borne de conduction, est reliée, de préférence connectée, au noeud 62. Une borne du transistor 60, par exemple une borne de conduction, c'est-à-dire le drain ou la source, est reliée, de préférence connectée, au noeud 62 et une autre borne, par exemple l'autre borne de conduction, est reliée, de préférence connectée, au noeud 16.

Le générateur 50 comprend un transistor 64, par exemple un transistor PMOS, et un condensateur 66 en série entre le noeud 14 d'application de la tension d'alimentation VDD et le noeud 16 d'application de la tension de référence GND. Plus précisément, le transistor 64 est reliée entre le noeud 14 et un noeud 68. Le condensateur 66 est relié entre le noeud 68 et le noeud 16. Plus précisément, une borne du transistor 64, par exemple une borne de conduction, c'est-à-dire le drain ou la source, est reliée, de préférence connectée, au noeud 14 et une autre borne, par exemple l'autre borne de conduction, est reliée, de préférence connectée, au noeud 68. Une borne du condensateur 66 est reliée, de préférence connectée, au noeud 68 et une autre borne est reliée, de préférence connectée, au noeud 16. Un interrupteur 70, par exemple un transistor, est par exemple reliés en parallèle du condensateur 66. Ainsi, l'interrupteur est couplé entre les noeuds 68 et 16, de préférence entre les bornes du condensateur 66. Plus précisément, une borne de l'interrupteur 70 est reliée, de préférence connectée, au noeud 68 et une autre borne de l'interrupteur 70 est reliée, de préférence connectée, au noeud 16. Par exemple, une borne de l'interrupteur 70 est reliée, de préférence connectée, à une borne du condensateur 66 et une autre borne de l'interrupteur 70 est reliée, de préférence connectée, à une autre borne du condensateur 66. Par exemple, l'interrupteur 70 est commandé par un signal représentatif de l'état du transistor 20 (figure 1). Par exemple, l'interrupteur 70 est ouvert lorsque le transistor 20 est passant et fermé lorsque le transistor 20 est bloqué. Par exemple, l'interrupteur 70 est commandé par le signal PWM (figure 1), lorsque le convertisseur fonctionne dans le premier mode de fonctionnement et par le signal PSK lorsque le convertisseur fonctionne dans le deuxième mode de fonctionnement.

Les transistors 54 et 60 sont commandés par un même signal de commande. Autrement dit, les bornes de commandes des transistors 54 et 60 sont reliées, de préférence connectées, entre elles.

Les transistors 58 et 64 sont reliés en miroir de courant. Les transistors 58 et 64 sont commandés par un même signal de commande. Autrement dit, les bornes de commandes des transistors 58 et 64 sont reliées, de préférence connectées, entre elles. De plus, les bornes de commandes des transistors 58 et 64 sont reliées, de préférence connectées, au noeud 62. Par exemple, les bornes de commandes des transistors 58 et 64 sont reliées, de préférence connectées, à la source du transistor 58.

Le générateur 50 comprend, en outre, un amplificateur opérationnel 72. L'amplificateur opérationnel 72 est alimenté par la tension d'alimentation VDD. L'amplificateur opérationnel est ainsi relié, de préférence connecté, par une entrée au noeud 14.

L'amplificateur opérationnel 72 comprend une entrée inverseuse (-) recevant une tension VDD/2 sensiblement égale à la moitié de la tension d'alimentation VDD. La tension VDD/2 est par exemple générée à partir de la tension d'alimentation VDD par un circuit non représenté, par exemple par un diviseur de tension non représenté. L'amplificateur opérationnel 72 comprend une entrée non inverseuse (+) reliée, de préférence connectée, au noeud 56. L'amplificateur opérationnel 72 comprend une sortie générant le signal de commande des transistors 54 et 60. Ainsi la sortie de l'amplificateur opérationnel 72 est reliée, de préférence connectée, aux bornes de commande des transistors 54 et 60.

Le générateur 50 comprend un condensateur 73couplé en série avec un interrupteur 74 entre le noeud 68 et le noeud 16. Le condensateur 73 et l'interrupteur 74 sont ainsi couplé en parallèle du condensateur 66.

La rampe de tension VRAMP est générée sur le noeud 68, qui constitue ainsi le noeud de sortie du générateur 50. Le noeud 68 est ainsi couplé au noeud 16 par au moins deux condensateurs, au moins un de ces condensateurs étant couplé en série avec un interrupteur entre le noeud 68 et le noeud 16.

L'interrupteur 74 est commandé par un signal P. L'interrupteur 74 comprend donc une borne de commande reliée, de préférence connectée, à un noeud d'application du signal P. L'interrupteur 74 est configuré pour être fermé lors du premier cycle de fonctionnement, c'est-à-dire durant la première phase d'accumulation d'énergie et la première phase de restitution d'énergie, après le passage du deuxième mode de fonctionnement au premier mode de fonctionnement. L'interrupteur 74 est configuré pour être ouvert lors des autres cycles de fonctionnement du premier mode de fonctionnement. Autrement dit, l'interrupteur 74 est configuré pour être fermé, lorsque le convertisseur est dans le premier mode de fonctionnement, de préférence lorsque le convertisseur passe du deuxième mode de fonctionnement au premier mode de fonctionnement, uniquement lors du premier cycle de fonctionnement. La fermeture de l'interrupteur 74 augmente la capacité de sortie du générateur de rampes de tension et augmente donc la durée de croissance de la rampe correspondant au premier cycle de fonctionnement du premier mode de fonctionnement.

Durant le deuxième mode de fonctionnement, l'interrupteur 74 est par exemple ouvert. Ainsi, la durée des phases d'accumulation d'énergie durant le deuxième mode de fonctionnement est sensiblement égale à la durée des phases d'accumulation d'énergie durant le premier mode de fonctionnement, à l'exception du premier cycle de fonctionnement.

A titre de variante, l'interrupteur 74 est par exemple fermé durant le deuxième mode de fonctionnement. La rampe de tension VRAMP a donc une pente différente durant le deuxième mode de fonctionnement et durant le premier mode de fonctionnement, à l'exception du premier cycle de fonctionnement. Ainsi, la durée des phases d'accumulation d'énergie durant le deuxième mode de fonctionnement est différente de la durée des phases d'accumulation d'énergie durant le premier mode de fonctionnement, à l'exception du premier cycle de fonctionnement.

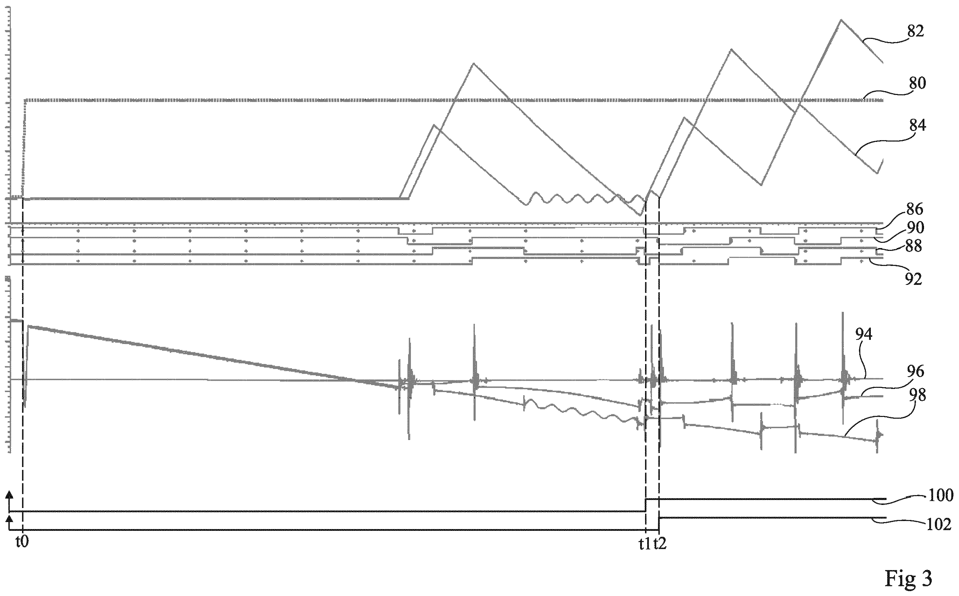

La figure 3 est un ensemble de chronogrammes illustrant le fonctionnement du mode de réalisation de la figure 2. Plus précisément, la figure 3 représente :
- le courant tiré par la charge, par une courbe 80 ;
- le courant traversant l'inductance 26 dans le cas où le générateur de rampes de tension 50 est celui décrit en relation avec la figure 2, par une courbe 82 ;
- le courant traversant l'inductance 26 dans le cas où le générateur de rampes de tension 50 ne comprend qu'un condensateur relié entre le noeud de sortie et le noeud de référence, par une courbe 84 ;
- le signal de commande du transistor 20, par une courbe 86, et le signal de commande du transistor 24, par une courbe 88, dans le cas où le générateur de rampes de tension 50 ne comprend qu'un condensateur relié entre le noeud de sortie et le noeud de référence ;
- le signal de commande du transistor 20, par une courbe 90, et le signal de commande du transistor 24, par une courbe 92, dans le cas où le générateur de rampes de tension 50 est celui décrit en relation avec la figure 2 ;
- la tension de consigne VREF, par une courbe 94 ;
- la tension de sortie VOUT dans le cas où le générateur de rampes de tension 50 est celui décrit en relation avec la figure 2, par une courbe 96 ;
- la tension de sortie VOUT dans le cas où le générateur de rampes de tension 50 ne comprend qu'un condensateur relié entre le noeud de sortie et le noeud de référence, par une courbe 98 ;
- le signal MODE dans le cas où le générateur de rampes de tension 50 ne comprend qu'un condensateur relié entre le noeud de sortie et le noeud de référence, par une courbe 100 ; et
- le signal MODE dans le cas où le générateur de rampes de tension 50 est celui décrit en relation avec la figure 2, par une courbe 102.

La figure 3 illustre le passage du deuxième mode de fonctionnement, c'est-à-dire le mode de fonctionnement de type PSK, vers le premier mode de fonctionnement, c'est-à-dire le mode de fonctionnement de type CCM.

Le fonctionnement du convertisseur comprend :
- des phases intermédiaires, durant lesquelles le courant traversant l'inductance (courbe 82 ou 84) est sensiblement nul et dans lequel les transistors 20 et 24 sont bloqués, ce qui correspond à une valeur haute du signal de commande du transistor 20 (courbe 86 ou 90) et une valeur basse du signal de commande du transistor 24 (courbe 88 ou 92) ;
- des phases d'accumulation d'énergie, durant lesquelles le courant traversant l'inductance (courbe 82 ou 84) est croissant et dans lequel le transistors 24 est bloqué et le transistor 20 est passant, ce qui correspond à une valeur basse du signal de commande du transistor 20 (courbe 86 ou 90) et une valeur basse du signal de commande du transistor 24 (courbe 88 ou 92) ; et
- des phases de restitution d'énergie, durant lesquelles le courant traversant l'inductance (courbe 82 ou 84) est croissant et dans lequel le transistors 20 est bloqué et le transistor 24 est passant, ce qui correspond à une valeur haute du signal de commande du transistor 20 (courbe 86 ou 90) et une valeur haute du signal de commande du transistor 24 (courbe 88 ou 92).

A un instant t0, le courant tiré par la charge augmente. Cela entraine une chute de la tension de sortie VOUT. Lorsque la tension VOUT descend en dessous de la valeur de consigne VREF, le convertisseur entre dans un cycle de fonctionnement du deuxième mode de fonctionnement PSK.

A la fin du cycle de fonctionnement, c'est-à-dire lorsque le courant traversant l'inductance 26 revient à zéro après au moins une phase d'accumulation d'énergie et une phase de restitution d'énergie (instant t1 pour le cas où le générateur de rampes de tension 50 ne comprend qu'un condensateur relié entre le noeud de sortie et le noeud de référence et instant t2 pour le cas où le générateur de rampes de tension 50 est celui décrit en relation avec la figure 2), le signal MODE passe d'une première valeur à une deuxième valeur de manière à indiquer le passage au premier mode de fonctionnement.

Après le passage dans le premier mode de fonctionnement, des cycles de fonctionnement s'enchainent de manière à faire augmenter le courant traversant l'inductance jusqu'à ce qu'il ait une valeur moyenne sensiblement égale au courant tiré par la charge.

Dans le cas où le générateur de rampe de tension est celui décrit en relation avec la figure 2, durant le premier cycle de fonctionnement, la capacité de sortie du générateur de rampes de tension est supérieure à la capacité de sortie du générateur de rampes de tension durant le reste des cycles de fonctionnement du premier mode de fonctionnement. Ainsi, la durée de la phase d'acquisition d'énergie est plus longue dans le premier cycle de fonctionnement du premier mode de fonctionnement que dans le reste des cycles de fonctionnement. Le courant traversant l'inductance 26 atteint donc plus rapidement la valeur de courant tiré par la charge. Dans l'exemple de la figure 3, la courbe 82 dépasse la courbe 80 dès le premier cycle de fonctionnement.

Le mode de réalisation de la figure 2, et plus précisément le condensateur 73, permet ainsi d'atteindre plus rapidement la valeur de courant voulue. Les courbes 96 et 98 permettent d'observer que la chute de tension causée au niveau de la tension de sortie VOUT par le changement de mode de fonctionnement est inférieure dans le cas de la courbe 96 par rapport au cas de la courbe 98.

Il est avantageux d'ouvrir de diminuer la capacité de sortie du générateur de rampes de tension après le premier cycle de fonctionnement du premier mode de fonctionnement pour ne pas augmenter la consommation d'énergie et pour ne pas augmenter la tension de sortie VOUT au-delà de la tension de consigne VREF.

A titre de variante, le condensateur 66 (figure 2) peut être couplé au noeud 68 par un interrupteur. Par exemple, la capacité du condensateur 73 peut être supérieure à la capacité du condensateur 66. Le condensateur de sortie du générateur correspond par exemple au condensateur 73 durant le premier cycle de fonctionnement du premier mode de fonctionnement et au condensateur 66 durant les autres cycles de fonctionnement du premier mode de fonctionnement. Ainsi, durant le premier cycle du premier mode de fonctionnement, l'interrupteur 74 est par exemple fermé et l'interrupteur couplé entre le condensateur 66 et le noeud de sortie est par exemple ouvert et inversement durant le reste des cycles de fonctionnement du premier mode de fonctionnement.

A titre de variante, le générateur 50 peut comprendre plus de deux condensateurs reliés entre le noeud de sortie et le noeud de référence. Par exemple, le générateur 50 peut comprendre au moins deux condensateurs, en plus du condensateur 66, chacun des au moins deux condensateurs étant reliés entre le noeud de sortie et le noeud de référence par un interrupteur. Les états, ouverts ou fermés, des interrupteurs sont choisis de telle manière que la capacité de sortie du générateur 50 durant le premier cycle de fonctionnement du premier mode de fonctionnement soit supérieure à sa capacité de sortie durant le reste des cycles de fonctionnement du premier mode de fonctionnement. Il est ainsi possible de choisir la capacité de sortie du générateur selon différents critères, par exemple selon la valeur du courant tiré ou selon la charge. Les signaux de commande d'au moins certains interrupteurs peuvent ainsi être différents.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Alimentation à découpage (10) comprenant un générateur (50) de rampes de tension, le générateur (50) étant configuré pour que la capacité de sortie (66, 73) du générateur (50) de rampes de tension ait une première valeur durant un premier cycle de fonctionnement d'un premier mode de fonctionnement et ait une deuxième valeur durant les cycles de fonctionnement suivants du premier mode de fonctionnement.

2. Procédé de commande d'une alimentation à découpage (10) comprenant un générateur (50) de rampes de tension, dans lequel la capacité de sortie (66, 73) du générateur de rampes de tension a une première valeur durant un premier cycle de fonctionnement d'un premier mode de fonctionnement et a une deuxième valeur durant les cycles de fonctionnement suivants du premier mode de fonctionnement.

3. Alimentation selon la revendication 1 ou procédé selon la revendication 2, dans lequel le générateur (50) comprend un premier condensateur (66) et au moins un deuxième condensateur (73), les premier et deuxième condensateurs étant couplés entre un noeud de sortie du générateur sur lequel est généré une rampe de tension (VRAMP) et un noeud (16) d'application d'une tension de référence (GND), le au moins un deuxième condensateur (73) étant couplé en série avec un interrupteur (74) entre le noeud de sortie et le noeud (16) d'application de la tension de référence, l'interrupteur (74) étant configuré pour être fermé durant le premier cycle de fonctionnement du premier mode de fonctionnement et ouvert durant le reste des cycles de fonctionnement du premier mode de fonctionnement.

4. Alimentation selon la revendication 1 ou 3 ou procédé selon la revendication 2 ou 3, dans lequel le premier condensateur (66) est relié en parallèle avec un interrupteur entre le noeud de sortie et le noeud d'application de la tension de référence.

5. Alimentation selon l'une quelconque des revendications 1, 3 ou 4 ou procédé selon l'une quelconque des revendications 2 à 4, dans lequel le générateur (50) de rampes de tension comprend au moins deux deuxièmes condensateurs.

6. Alimentation ou procédé selon la revendication 5, dans lequel au moins certains des interrupteurs reliés en série avec les deuxièmes condensateurs sont commandés par des signaux de commande différents.

7. Alimentation selon l'une quelconque des revendications 1, 3 à 6 ou procédé selon l'une quelconque des revendications 2 à 6, dans lequel le premier mode de fonctionnement est un mode de conduction continue.

8. Alimentation selon l'une quelconque des revendications 1, 3 à 7 ou procédé selon l'une quelconque des revendications 2 à 7, dans lequel l'alimentation comprend un deuxième mode de fonctionnement dit mode de suppression d'impulsion.

9. Alimentation ou procédé selon la revendication 8, dans lequel l'alimentation comprend un troisième circuit de commande (40) du deuxième mode de fonctionnement comprenant un troisième comparateur configuré pour comparer une rampe de tension (VRAMP) générée par le générateur de rampes de tension (50) et une tension de consigne (VREF), le troisième comparateur étant configuré pour fournir un deuxième signal de sortie (PSK) au premier circuit.

10. Alimentation selon l'une quelconque des revendications 1, 3 à 9 ou procédé selon l'une quelconque des revendications 2 à 9, dans lequel l'alimentation comprend des premier (20) et deuxième (24) transistors reliés en série entre un noeud (14) d'application d'une tension d'alimentation (VDD) et un noeud (16) d'application d'une tension de référence (GND), les premier et deuxième transistors étant reliés l'un à l'autre par un nœud interne (22), les premier et deuxième transistors étant commandés par un premier circuit (32) de génération des signaux de commande des premier et deuxième transistors.

11. Alimentation ou procédé selon la revendication 10, dans lequel l'alimentation comprend un deuxième circuit de commande (34) du premier mode de fonctionnement, le deuxième circuit (34) comprenant un premier comparateur (36) configuré pour comparer une tension de sortie de l'alimentation (VOUT) et une tension de consigne (VREF) et un deuxième comparateur (38) configuré pour comparer une sortie du premier comparateur (36) à une rampe de tension généré par le générateur (50) de rampes de tension, le deuxième comparateur étant configuré pour fournir un signal de sortie (PWM) au premier circuit (32).

12. Alimentation selon l'une quelconque des revendications 1, 3 à 11 ou procédé selon l'une quelconque des revendications 2 à 11, dans lequel le générateur (50) de rampes de tension comprend :
- une résistance (52) reliée en série avec un premier transistor (54) entre le noeud d'application de la tension d'alimentation et le noeud d'application de la tension de référence ;
- un deuxième transistor (58) et un troisième transistor (60) reliés en série entre le noeud d'application de la tension d'alimentation et le noeud d'application de la tension de référence ;
- un quatrième transistor (64) couplé entre le noeud d'application de la tension d'alimentation et le noeud de sortie, les deuxièmes et quatrième transistors étant reliés en miroir de courant ; et
un amplificateur opérationnel (73), une entrée de l'amplificateur opérationnel étant reliée à un noeud reliant la résistance et le premier transistor et une autre entrée de l'amplificateur opérationnel étant reliée à un noeud d'application d'une tension sensiblement égale à la moitié de la tension d'alimentation, une sortie de l'amplificateur opérationnel étant reliée aux bornes de commandes des premier et troisième transistors.
